# EUROPEAN PATENT APPLICATION

(11) **EP 4 560 611 A1**
(43) Date of publication of application: **28.05.2025**
(21) Application number: 22757820.0
(22) Date of filing: 08.08.2022
(51) Int. Cl.: G09F 9/302, G09F 9/33, G09G 3/32, G09G 3/3225

(54) **DISPLAY PANEL, TILED DISPLAY MODULE, AND MANUFACTURING METHOD FOR TILED DISPLAY MODULE**

(30) Priority: 18.07.2022 CN 202210843822
(71) Applicant: Shenzhen China Star Optoelectronics Semiconductor Display Technology Co., Ltd., Shenzhen, Guangdong 518132 (CN)
(72) Inventor: LI, Zhuhui, Guangdong 518132 (CN); LI, Yanfen, Guangdong 518132 (CN)
(74) Representative: Ström & Gulliksson AB
(86) International application number: PCT/CN2022/110757
(87) International publication number: WO 2024/016394

(57) **Abstract**

A display panel, a spliced display module, and a method of manufacturing the spliced display module are provided. The display panel includes a first display area and a second display area located at a periphery of the first display area at least in a first direction. A first pixel group is arranged in the second display area and includes a first light-emitting assembly, a first driving assembly, a second driving assembly, and a second light-emitting assembly that are sequentially arranged in the first direction.

## Description

### 1. FIELD OF INVENTION

The present application relates to a technical field of displays, and particularly to a display panel, a spliced display module, and a method of manufacturing the spliced display module.

### 2. RELATED ART

A lot of new display technologies have been emerging in recent years, such as quantum dot light-emitting diode (QLED) displays, electronic ink (E-ink) screens, flexible liquid crystal displays (LCDs), and Perovskite light-emitting diode (PeLED) displays, mini light-emitting diodes (mini LEDs), micro light-emitting diodes (micro LEDs), and so on. However, these new technologies still have some problems, such as cost, lifespan, reliability, etc., and do not have the same high mass production as LCDs and organic light-emitting diodes (OLEDs). Specifically, micro LEDs refer to technologies that use micron-sized LEDs as light-emitting pixel units which are assembled them with driving modules to form high-density display arrays. Compared with current mainstream display technologies, such as LCDs and OLEDs, micro LEDs are provided with crossgenerational advantages in terms of brightness, resolution, energy consumption, service life, response times, and thermal stability, and are an internationally recognized future display technology.

Large-sized display markets are huge, such as shopping mall advertisements, center consoles, conference rooms, gymnasiums, and so on. Currently, there are four main types of large-sized displays as follows:
(1) LCD spliced screens: the cost of this solution is low, but it can only be used indoors, and there are obvious splicing seams;
(2) Small-pitch LED spliced screens on printed circuit board (PCB) boards: this technology can realize seamless splicing and high-brightness display, but the resolution is low, and modules are huge and complex;
(3) Projection displays: this technology is known for low brightness and poor quality of picture, and images are prone to deformed, which can only meet general requirements for indoor offices; and
(4) Glass-based mini LED spliced screens: this technology can achieve seamless splicing and high-brightness, high-resolution display, and is thin and beautiful. The disadvantage is that mini LED chips are large and graininess is obvious, which is not suitable for close viewing.

Compared with the above solutions, glass-based micro-LED spliced screens not only have all advantages of the glass-based mini LED spliced screens, but also have advantages of higher resolution and more delicate picture quality, thus offering better display characteristics and being suitable for large-size displaying.

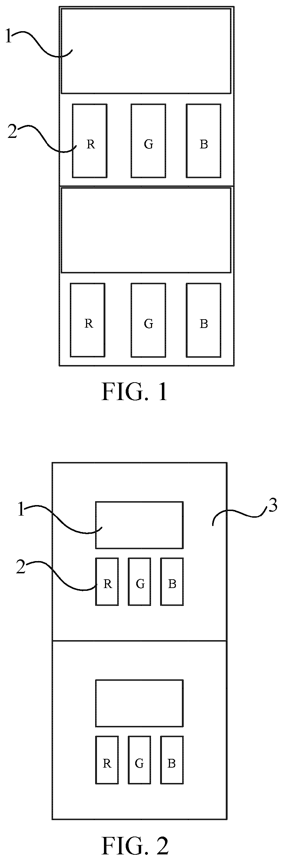

As shown in FIG. 1, a pixel unit in prior art generally includes a driving assembly 1 and a light-emitting assembly 2. The light-emitting assembly 2 is arranged on one side of the driving assembly 1, and a width of the driving assembly 1 is equal to a width of the pixel unit. When a screen is spliced, a seam is large, which adversely affects visual effects. In order to solve the seam problem, as shown in FIG. 2, the light-emitting assembly 2 can use small-sized LED lamp beads, and set a negative tolerance area 3 around the pixel unit. The splicing redundancy can meet the effect of seamless splicing, but this solution is only suitable for low-resolution spliced screens, not for high-resolution spliced screens.

During the research and practice of the prior art, the inventor of the present application found that, as shown in FIG. 2, the seam can be reduced by setting a negative tolerance on the pixel unit. Specifically, a space of the driving component 1 is compressed, and the negative tolerance area 3 is formed around the driving component 1 and the light-emitting component 2. When screens using the above pixel unit are spliced, the negative tolerance area 3 at an edge of the screen can be cut off to increase a splicing margin, so that a seamless splicing effect can be satisfied, but the solution of FIG. 2 still cannot eliminate the seam well.

Therefore, it is imperative to provide a technical solution to solve the above-mentioned problem.

### SUMMARY OF INVENTION

Embodiments of the present application provide a display panel, a spliced display module, and a method of manufacturing the spliced display module that are capable of solving a technical problem that it is difficult to eliminate seams of spliced screens.

An embodiment of the present application provides a display panel including a first display area and a second display area located at a periphery of the first display area at least in a first direction.

The display panel includes a plurality of first pixel groups arranged in the second display area, wherein each of the first pixel groups includes a first driving assembly, a second driving assembly, a first light-emitting assembly, and a second light-emitting assembly, wherein the first driving assembly is electrically connected to the first light-emitting assembly, and the second driving assembly is electrically connected to the second light-emitting assembly; wherein in the first pixel group, the first driving assembly is arranged on a side of the first light-emitting assembly in the first direction, the second driving assembly is arranged on a side of the first driving assembly away from the first light-emitting assembly in the first direction, and the second light-emitting assembly is arranged on a side of the second driving assembly away from the first driving assembly in the first direction.

Optionally, in some embodiments of the present application, in the first pixel group, the first driving assembly and the second driving assembly are arranged in an axisymmetric arrangement, and the first driving assembly and the second driving assembly have a same structure.

Optionally, in some embodiments of the present application, the display panel further includes a plurality of second pixel groups disposed in the first display area, and the first pixel groups and the second pixel groups are distributed in an array.

Optionally, in some embodiments of the present application, the first pixel group and the second pixel group have a same structure.

Optionally, in some embodiments of the present application, a pixel pitch of the first pixel group is equal to a pixel pitch of the second pixel group.

Optionally, in some embodiments of the present application, the first driving assembly includes at least a first thin-film transistor, the first light-emitting assembly includes at least a light-emitting device, and the first thin-film transistor is electrically connected to a corresponding one of the light-emitting devices.

Optionally, in some embodiments of the present application, the display panel further includes a plurality of gate lines, a plurality of data lines, a plurality of first power lines, and a plurality of second power lines.

The first driving assembly further includes at least a second thin-film transistor having a control terminal electrically connected to a corresponding one of the gate lines, an input terminal of the second thin-film transistor is electrically connected to a corresponding one of the data lines, an output terminal of the second thin-film transistor is electrically connected to a control terminal of the first thin-film transistor, and an input terminal of the first thin-film transistor is electrically connected to a corresponding one of the first power lines.

The light-emitting device includes a first pin and a second pin, the output terminal of the first thin-film transistor is electrically connected to the first pin of the light-emitting device, and the second pin of the light-emitting device is electrically connected to a corresponding one of the second power lines.

Optionally, in some embodiments of the present application, the first driving assembly further includes at least a storage capacitor, and the output terminal of the second thin-film transistor is connected to the output terminal of the first thin-film transistor through the storage capacitor.

Optionally, in some embodiments of the present application, the display panel further includes a first signal line and a second signal line.

The first driving assembly further includes at least a third thin-film transistor having a control terminal electrically connected to the first signal line, an input terminal of the third thin-film transistor is electrically connected to the second signal line, and an output terminal of the third thin-film transistor is electrically connected to the output terminal of the first thin-film transistor.

Embodiments of the present application further provide a spliced display module, including at least two display panels spliced together, and the display panels adopt the above-mentioned display panels.

Optionally, in some embodiments of the present application, in the first pixel group, the first driving assembly and the second driving assembly are arranged in an axisymmetric arrangement, and the first driving assembly and the second driving assembly have a same structure.

Optionally, in some embodiments of the present application, the display panel further includes a plurality of second pixel groups disposed in the first display area, and the first pixel groups and the second pixel groups are distributed in an array.

Optionally, in some embodiments of the present application, the first pixel group and the second pixel group have a same structure.

Optionally, in some embodiments of the present application, a pixel pitch of the first pixel group is equal to a pixel pitch of the second pixel group.

Optionally, in some embodiments of the present application, the first driving assembly includes at least a first thin-film transistor, the first light-emitting assembly includes at least a light-emitting device, and the first thin-film transistor is electrically connected to a corresponding one of the light-emitting devices.

Optionally, in some embodiments of the present application, the display panel further includes a plurality of gate lines, a plurality of data lines, a plurality of first power lines, and a plurality of second power lines.

The first driving assembly further includes at least a second thin-film transistor having a control terminal electrically connected to a corresponding one of the gate lines, an input terminal of the second thin-film transistor is electrically connected to a corresponding one of the data lines, an output terminal of the second thin-film transistor is electrically connected to a control terminal of the first thin-film transistor, and an input terminal of the first thin-film transistor is electrically connected to a corresponding one of the first power lines.

The light-emitting device includes a first pin and a second pin, the output terminal of the first thin-film transistor is electrically connected to the first pin of the light-emitting device, and the second pin of the light-emitting device is electrically connected to a corresponding one of the second power lines.

Optionally, in some embodiments of the present application, the first driving assembly further includes at least a storage capacitor, and the output terminal of the second thin-film transistor is connected to the output terminal of the first thin-film transistor through the storage capacitor.

Optionally, in some embodiments of the present application, the display panel further includes a first signal line and a second signal line.

The first driving assembly further includes at least a third thin-film transistor having a control terminal electrically connected to the first signal line, an input terminal of the third thin-film transistor is electrically connected to the second signal line, and an output terminal of the third thin-film transistor is electrically connected to the output terminal of the first thin-film transistor.

An embodiment of the present application further provides a method of manufacturing a spliced display module, including:
Step B1: providing at least two display panels, wherein each of the display panels includes a first display area, a second display area, and a negative tolerance area, a plurality of first pixel groups arranged in the second display area. The second display area is located at a periphery of the first display area at least in a first direction, and the negative tolerance area is located on a side of the second display area away from the first display area. A plurality first pixel groups are arranged in the second display area, each of the first pixel groups includes a first driving assembly, a second driving assembly, a first light-emitting assembly, and a second light-emitting assembly. The first driving assembly is electrically connected to the first light-emitting assembly, and the second driving assembly is electrically connected to the second light-emitting assembly. In the first pixel group, the first driving assembly is arranged on a side of the first light-emitting assembly in the first direction, the second driving assembly is arranged on a side of the first driving assembly away from the first light-emitting assembly in the first direction, and the second light-emitting assembly is arranged on a side of the second driving assembly away from the first driving assembly in the first direction.
Step B2: removing the negative tolerance area of the display panel;
Step B3: splicing the at least two display panels together to obtain the spliced display module.

Optionally, in some embodiments of the present application, in Step B1, a width of the negative tolerance area is greater than or equal to 0.2 millimeters (mm), and the width of the negative tolerance area is less than or equal to 0.6 mm.

The present application has advantageous effects as follows: the embodiments of the present application provide the display panel, the spliced display module, and the method of manufacturing the spliced display module. By arranging the first driving assembly and the second driving assembly between the first light-emitting assembly and the second light-emitting assembly in this application, a space between the first light-emitting assembly and the second light-emitting assembly can be fully utilized, which increases the negative tolerance of the display panel in the first direction. In addition, the light-emitting assemblies are arranged throughout outermost parts of the display panel 10 in the first direction, which can effectively eliminate seams.

### BRIEF DESCRIPTION OF DRAWINGS

In order to illustrate the technical solutions more clearly in the embodiments of the present application, the following will briefly introduce the accompanying drawings that need to be used in the description of the embodiments. Apparently, the accompanying drawings in the following description show merely some embodiments of the present invention, and a person skilled in the art may still derive other drawings from these accompanying drawings without creative efforts.
FIG. 1 is a schematic structural view of a conventional pixel unit.
FIG. 2 is a schematic structural view of an improved pixel unit.
FIG. 3 is a schematic structural view of a display panel according to an embodiment of the present application.
FIG. 4 is a schematic structural view of a first pixel group according to an embodiment of the present application.
FIG. 5 is a comparison schematic diagram of the pixel unit of FIG. 2 and the first pixel group of the present application.
FIG. 6 is a schematic diagram of a principle of a display panel according to an embodiment of the present application.
FIG. 7 is a schematic top plan view of a pixel unit according to an embodiment of the present application.
FIG. 8 is an equivalent circuit diagram of a pixel unit according to an embodiment of the present application.
FIG. 9 is a schematic cross-sectional structural view of a first thin-film transistor according to an embodiment of the present application.
FIG. 10 is a schematic cross-sectional structural view of a second thin-film transistor according to an embodiment of the present application.
FIG. 11 is a schematic cross-sectional structural view of a storage capacitor according to an embodiment of the present application.
FIG. 12 is a schematic cross-sectional structural view of a third thin-film transistor according to an embodiment of the present application.
FIG. 13 is a schematic structural view of a spliced display module according to an embodiment of the present application.

### DESCRIPTION OF PREFERRED EMBODIMENTS

The technical solutions in the embodiments of the present application will be clearly and completely described below with reference to the drawings in the embodiments of the present application. Obviously, the described embodiments are only a part of the embodiments of the present application, but not all of the embodiments. Based on the embodiments in this application, all other embodiments obtained by those skilled in the art without creative work shall fall within the protection scope of this application. It should be understood that the specific embodiments described here are only used to illustrate the present application, and are not used to limit the present application. In this application, if no explanation is made to the contrary, the orientation words used, such as "upper" and "lower" usually refer to the upper and lower positions of the device in actual use or working state. Specifically, they refer to the direction of the drawings, and "inner" and "outer" refer to the outline of the device.

Embodiments of the present application provide a display panel, a spliced display module, and a method of manufacturing the spliced display module. Detailed descriptions are given below. It should be noted that the description order of the following embodiments is not intended to limit the preferred order of the embodiments.

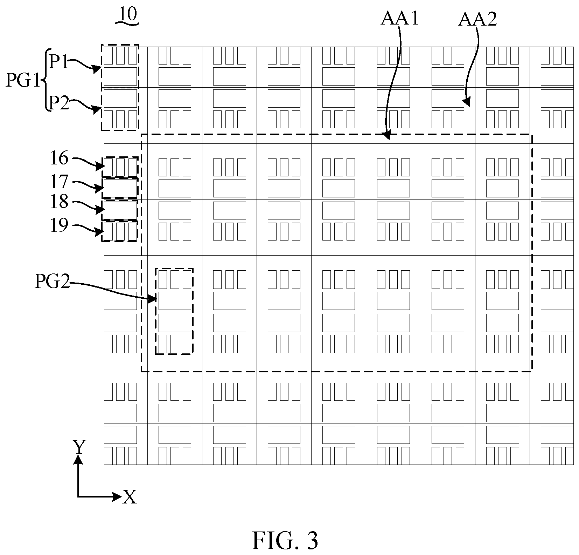

Referring to FIG. 3, an embodiment of the present application provides a display panel 10. The display panel 10 includes a first display area AA1 and a second display area AA2, and the second display area AA2 is arranged on a periphery of the first display area AA1 at least in a first direction Y, that is, compared to the first display area AA1, the second display area AA2 is closer to an edge of the display panel 10 in the first direction Y than the first display area AA1. In the embodiment of the present application, the second display area AA2 surrounds the first display area AA1. Certainly, according to actual selection and specific requirements, the second display area AA2 can only be arranged on a side of the periphery of the first display area AA1 in the first direction Y, or the second display area AA2 is arranged on opposite sides of the periphery of the first display area AA1 in the first direction Y, which is not limited herein.

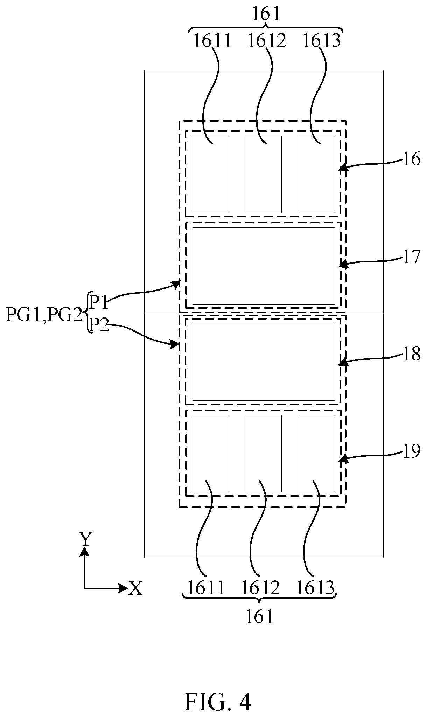

Specifically, referring to FIGs. 3 and 4, the display panel 10 includes a plurality of first pixel groups PG1 disposed in the second display area AA2. Each of the first pixel groups PG1 includes a first pixel unit P1 and a second pixel unit P2, and the first pixel unit P1 is disposed on a side of the second pixel unit P2 in the first direction Y. Specifically, the first pixel unit P1 includes a first driving assembly 17 and a first light-emitting assembly 16. The first driving assembly 17 is electrically connected to the first light-emitting assembly 16 and is configured to control turn-on and turn-off of the first light-emitting assembly 16. The second pixel unit P2 includes a second driving assembly 18 and a second light-emitting assembly 19. The second driving assembly 18 is electrically connected to the second light-emitting assembly 19 and is configured to control turn-on and turn-off of the second light-emitting assembly 19.

In one of the first pixel groups PG1, the first driving assembly 17 is arranged in the first direction Y on a side of the first light-emitting assembly 16, and the second driving assembly 18 is arranged in the first direction Y on a side of the first driving assembly 17 away from the first light-emitting assembly 16. The second light-emitting assembly 19 is arranged in the first direction Y on a side of the second driving assembly 18 away from the first driving assembly 17. That is, the first light-emitting assembly 16, the first driving assembly 17, the second driving assembly 18, and the second light-emitting assembly 19 are sequentially arranged in the first direction Y.

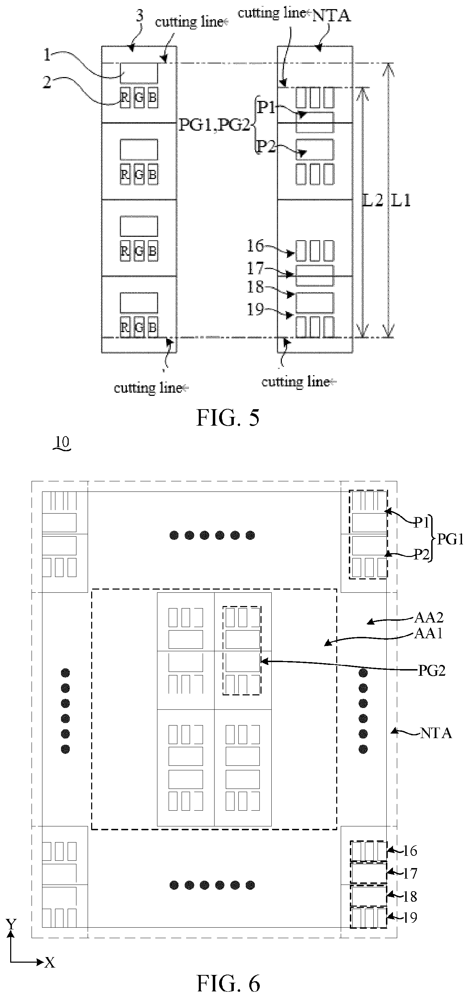

As shown in FIG. 5, FIG. 5 is a comparison schematic diagram of the pixel unit of FIG. 2 and the first pixel group of the present application. In the case of a same pixel pitch, on the basis of the pixel units shown in FIG. 2, the driving assembly 1 of the pixel unit located above the adjacent pixel unit is transferred to a lower part of the light-emitting assembly 2, so as to obtain the first pixel group PG1 of the present application. In contrast, after an outermost negative tolerance area 3 of the display panel 10 corresponding to the pixel unit of FIG. 2 is removed, a length of the display panel 10 in the first direction Y is L1. After an outermost negative tolerance area NTA of the display panel 10 corresponding to the first pixel group PG1 of the present application is removed, a length of the display panel 10 in the first direction Y is L2, which obviously is less than the length L1. It can be seen from this that, by arranging the first driving assembly 17 and the second driving assembly 18 between the first light-emitting assembly 16 and the second light-emitting assembly 19 in this application, a space between the first light-emitting assembly 16 and the second light-emitting assembly 19 can be fully utilized, which increases the negative tolerance of the display panel 10 in the first direction Y. In addition, light-emitting assemblies are arranged throughout outermost parts of the display panel 10 in the first direction Y, which can effectively eliminate seams.

It should be noted that, as shown in FIG. 5, in the display panel 10 corresponding to the first pixel group PG1 of the present application, a negative tolerance with respect to an upper part of the display panel 10 is relatively large, that is, a margin of the negative tolerance of the display panel 10 with respect to the upper part in the first direction Y is large. In order to make a negative tolerance with respect to a lower part consistent with the negative tolerance with respect to the upper part, positions of all pixel units in the display panel 10 can be adjusted so that all pixel units in the display panel 10 are centered, thus making the negative tolerance with respect to the lower part consistent with the negative tolerance with respect to the upper part. Similarly, since the negative tolerance of the display panel 10 in the first direction Y is relatively large, in order to increase a negative tolerance on left and right sides of the display panel 10, shapes of the first driving assembly 17, the second driving assembly 18, the first light-emitting assembly 16, and the second light-emitting assembly 19 can be adjusted. For example, lengths of the first driving assembly 17, the second driving assembly 18, the first light-emitting assembly 16, and the second light-emitting assembly 19 are increased in the first direction Y, and widths of the first driving assembly 17, the second driving assembly 18, the first light-emitting assembly 16, and the second light-emitting assembly 19 in the second direction X are reduced, so that the negative tolerances with respect to the upper, lower, left, and right parts of the display panel 10 are increased.

It should be noted that an angle between the first direction Y and the second direction X is greater than 0° and less than or equal to 90°. In this embodiment of the present application, the first direction Y and the second direction X are perpendicular. Certainly, according to actual situations and specific requirements, the angle between the first direction Y and the second direction X can be adjusted appropriately, which is not limited here.

In the embodiment of the present application, each of the first light-emitting assembly 16 and the second light-emitting assembly 19 includes a plurality of light-emitting devices 161, which may be light-emitting diodes (LEDs), mini LEDs, micro LEDs, organic light-emitting diodes (OLEDs), etc., which are not limited herein. The first driving assembly 17 and the second driving assembly 18 refer to assemblies for driving the light-emitting device 161 to work, and may specifically include, but are not limited to, assemblies, such as thin-film transistors and capacitors.

As shown in FIGs. 3 to 6, after the negative tolerance area NTA is cut off in the display panel 10 in the embodiment of the present application, a nonluminous area at an edge can be reduced. A seamless spliced display module can be obtained by using the display panel 10 of the embodiment of the present application that is conducive to achieving a high-resolution spliced display module.

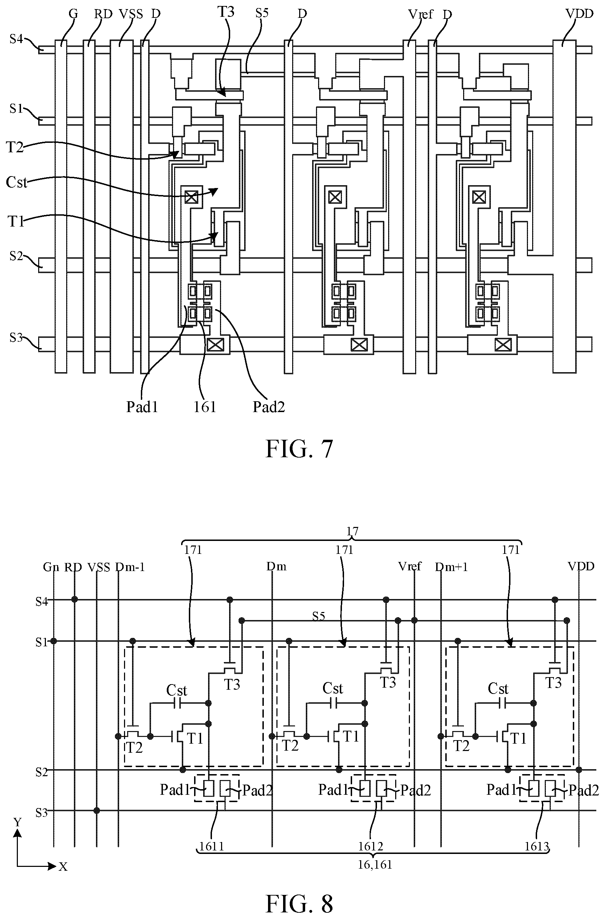

Specifically, as shown in FIGs. 7 to 9, the first driving assembly 17 includes at least a sub-driving group 171, and the first light-emitting assembly 16 includes at least a light-emitting device 161. The sub-driving groups 171 and the light-emitting devices 161 are in a one-to-one correspondence. Each of the sub-driving groups 171 is electrically connected to a corresponding one of the light-emitting devices 161. In the embodiment of the present application, the driving assembly includes three sub-driving groups 171. The first light-emitting assembly 16 includes three light-emitting devices 161, and the three light-emitting devices 161 are a red light-emitting device 1611, a green light-emitting device 1612, and a blue light-emitting device 1613, respectively. Each sub-driving group 171 is electrically connected to the corresponding light-emitting device 161. It should be noted that the red light-emitting device 1611 refers to the light-emitting device 161 for emitting red light, the green light-emitting device 1612 refers to the light-emitting device 161 for emitting green light, and the blue light-emitting device 1613 refers to the light-emitting device 161 for emitting blue light.

It can be understood that the number of sub-driving groups 171 of the first driving assembly 17 and the number of light-emitting devices 161 of the first light-emitting assembly 16 can be adjusted appropriately according to actual situations and specific requirements, which are not limited here.

Specifically, as shown in FIGS. 7 to 9, the sub-driving group 171 includes a first thin-film transistor T1 electrically connected to the corresponding light-emitting device 161, so that the first thin-film transistor T1 can drive the corresponding light-emitting device 161 to operate. With this structure, the light-emitting device 161 can be controlled to be turned on and off by a thin-film transistor, which has a simple structure for easy implementation.

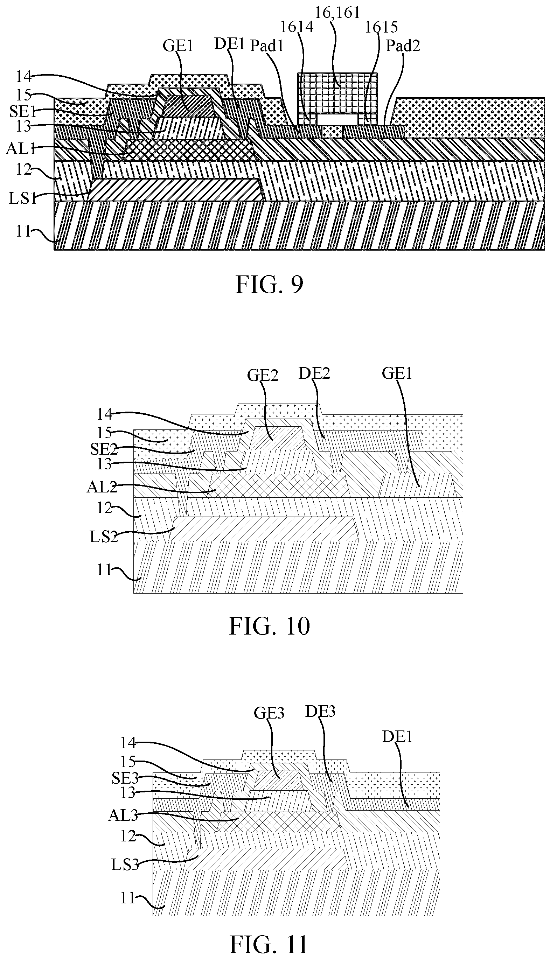

Specifically, as shown in FIG. 9, the display panel 10 includes a substrate 11, a first light shielding electrode LS1, a buffer layer 12, a first active layer AL1, a gate insulating layer 13, a first gate GE1, an interlayer dielectric layer 14, a first source electrode SE1, a first drain electrode DE1, and a passivation layer 15. The first light shielding electrode LS1 is disposed on the substrate 11, and the buffer layer 12 covers the substrate 11 and the first light shielding electrode LS1. The first active layer AL1 is disposed on the buffer layer 12, and the first active layer AL1 is disposed corresponding to the first light shielding electrode LS1. The gate insulating layer 13 is disposed on the first active layer AL1, the first gate GE1 is disposed on the gate insulating layer 13, and the first gate GE1 is disposed corresponding to the first active layer AL1. The interlayer dielectric layer 14 covers the first active layer AL1, the gate insulating layer 13, and the first gate electrode GE1. The first source electrode SE1 and the first drain electrode DE1 are disposed on the interlayer dielectric layer 14 at intervals, and the first source electrode SE1 is electrically connected to the first light shielding electrode LS1. The first source electrode SE1 is electrically connected to one end of the first active layer AL1, and the first drain electrode DE1 is electrically connected to the other end of the first active layer AL1. The passivation layer 15 covers the interlayer dielectric layer 14, the first source electrode SE1, and the first drain electrode DE1.

In the embodiment of the present application, the first active layer AL1, the first gate GE1, the first source electrode SE1, and the first drain electrode DE1 form the first thin-film transistor T1. Specifically, a control terminal of the first thin-film transistor T1 is the first gate GE1, an input terminal is the first source electrode SE1, and an output terminal is the first drain electrode DE1.

Specifically, the display panel 10 further includes a first pad Pad1, which is electrically connected to the first drain electrode DE1. The light-emitting device 161 includes a first pin 1614 bonded to the first solder pad Pad1, so that the first thin-film transistor T1 is electrically connected to the light-emitting device 161.

Specifically, as shown in FIGs. 7, 8, and 10, the display panel 10 further includes a plurality of gate lines G, a plurality of data lines D, a first power line VDD, and a second power line VSS. The sub-driving group 171 further includes a second thin-film transistor T2. A control terminal of the second thin-film transistor T2 is electrically connected to the gate line G, an input terminal of the second thin-film transistor T2 is electrically connected to the data line D, and an output terminal of the second thin-film transistor T2 is electrically connected to the control terminal of the first thin-film transistor T1, and the input terminal of the first thin-film transistor T1 is electrically connected to the first power line VDD. Referring to FIG. 9, the light-emitting device 161 further includes a second pin 1615 electrically connected to the second power line VSS.

Specifically, as shown in FIG. 10, the display panel 10 further includes a second light shielding electrode LS2, a second active layer AL2, a second gate electrode GE2, a second source electrode SE2, and a second drain electrode DE2 . The second light-shielding electrode LS2 is disposed on the substrate 11 and is spaced apart from the first light-shielding electrode LS1. The buffer layer 12 further covers the second light-shielding electrode LS2. The second active layer AL2 is disposed on the buffer layer 12 and is disposed corresponding to the second light shielding electrode LS2. The gate insulating layer 13 is further disposed on the second active layer AL2, the second gate GE2 is disposed on the gate insulating layer 13, and the second gate GE2 is disposed corresponding to the second active layer AL2. The interlayer dielectric layer 14 covers the second active layer AL2 and the second gate GE2. The second source electrode SE2 and the second drain electrode DE2 are disposed on the interlayer dielectric layer 14 at intervals, and the second source electrode SE2 is electrically connected to the second light shielding electrode LS2. The second source electrode SE2 is electrically connected to one end of the second active layer AL2, and the second drain electrode DE2 is electrically connected to the other end of the second active layer AL2. The passivation layer 15 further covers the second source electrode SE2 and the second drain electrode DE2.

In the embodiment of the present application, the second active layer AL2, the second gate GE2, the second source electrode SE2, and the second drain electrode DE2 form the second thin-film transistor T2. Specifically, the control terminal of the second thin-film transistor T2 is the second gate GE2, the input terminal is the second source electrode SE2, and the output terminal is the second drain electrode DE2. The first source electrode SE1 is electrically connected to the first power line VDD, the second pin 1615 is electrically connected to the second power line VSS, the second gate GE2 is electrically connected to the gate line G, the second source electrode SE2 is electrically connected to the data line D, and the second drain electrode DE2 is electrically connected to the first gate GE1.

Specifically, as shown in FIGs. 7 to 9, the display panel 10 further includes a second pad Pad2 electrically connected to the second power line VSS, and the second pin 1615 is bonded to the second pad Pad2.

Specifically, as shown in FIGs. 7 , 8, and 11, the display panel 10 further includes a first signal line RD and a second signal line Vref. The first driving assembly 17 further includes at least a third thin-film transistor T3. A control terminal of the third thin-film transistor T3 is electrically connected to the first signal line RD, an input terminal of the third thin-film transistor T3 is electrically connected to the second signal line Vref, and an output terminal of the third thin-film transistor T3 is electrically connected to the output terminal of the first thin-film transistor T1. With this structure, when it is detected that a threshold voltage of the first thin-film transistor T1 is abnormal, a compensation voltage can be provided for the output terminal of the first thin-film transistor T1.

Specifically, as shown in FIG. 11, the display panel 10 further includes a third light shielding electrode LS3, a third active layer AL3, a third gate GE3, a third source electrode SE3, and a third drain electrode DE3. The third light-shielding electrode LS3 is disposed on the substrate 11. The third light-shielding electrode LS3, the second light-shielding electrode LS2, and the first light-shielding electrode LS1 are spaced apart from each other, and the buffer layer 12 further covers the third light-shielding electrode LS3. The third active layer AL3 is disposed on the buffer layer 12, and the third active layer AL3 is disposed corresponding to the third light shielding electrode LS3. The gate insulating layer 13 is further disposed on the third active layer AL3. The third gate GE3 is disposed on the gate insulating layer 13 and is located corresponding to the third active layer AL3. The interlayer dielectric layer 14 covers the third active layer AL3 and the third gate electrode GE3. The third source electrode SE3 and the third drain electrode DE3 are disposed on the interlayer dielectric layer 14 at intervals. Third source electrode SE3 is electrically connected to the third light shielding electrode LS3 and is electrically connected to one end of the third active layer AL3. The third drain electrode DE3 is electrically connected to the other end of the third active layer AL3. The passivation layer 15 further covers the third source electrode SE3 and the third drain electrode DE3.

In the embodiment of the present application, the third active layer AL3, the third gate GE3, the third source electrode SE3, and the third drain electrode DE3 form the third thin-film transistor T3. Specifically, the control terminal of the third thin-film transistor T3 is the third gate GE3, the input terminal is the third source electrode SE3, the output terminal is the third drain electrode DE3, and the third drain electrode DE3 is electrically connected to the first drain electrode DE1.

Specifically, as shown in FIGs. 7, 8, and 12, the sub-driving group 171 further includes a storage capacitor Cst. The output terminal of the second thin-film transistor T2 is connected to the output terminal of the first thin-film transistor T1 through the storage capacitor Cst. Specifically, the storage capacitor Cst includes a first capacitor C1 and a second capacitor C2, which are connected in parallel. Specifically, the first capacitor C1 is formed between the first drain electrode DE1 and the first gate electrode GE1, and the second capacitor C2 is formed between the first light shielding electrode LS1 and the first gate GE1.

Specifically, in the same first pixel group PG1, the first pixel unit P1 and the second pixel unit P2 are disposed in an axisymmetric arrangement, that is, the first driving assembly 17 and the second driving assembly 18 are arranged in an axisymmetric arrangement, and the first light-emitting assembly 16 and the second light-emitting assembly 19 are arranged in an axisymmetric arrangement. In addition, the first driving assembly 17 and the second driving assembly 18 have a same structure, and structures of the first light-emitting assembly 16 and the second light-emitting assembly 19 are the same. Specifically, the first driving assembly 17 and the second driving assembly 18 have a same structure, and structures of the first light-emitting assembly 16 and the second light-emitting assembly 19 are the same, which means that the second driving assembly 18 also includes at least one sub-driving group 171. The second light-emitting assembly 19 includes at least one light-emitting device 161. The sub-driving groups 171 of the second driving assembly 18 are in a one-to-one correspondence with the light-emitting devices 161 of the second light-emitting assembly 19. The sub-driving groups 171 of each of the second driving assemblies 18 are electrically connected to corresponding light-emitting device 161 of the second light-emitting assembly 19. The first driving assembly 17 and the second driving assembly 18 are disposed in an axisymmetric arrangement, and the first light-emitting assembly 16 and the second light-emitting assembly 19 are disposed in an axisymmetric arrangement, which means that the layout of elements in the first driving assembly 17 and the layout of elements in the second driving assembly 18 are arranged in an axisymmetric arrangement, and the layout of the light-emitting devices 161 in the first light-emitting assembly 16 and the layout of the light-emitting devices 161 in the second light-emitting assembly 19 are arranged in an axisymmetric arrangement.

Specifically, the gate line G, the data lines D, the first power line VDD, the second power line VSS, the first signal line RD, and the second signal line Vref are arranged in parallel. Specifically, the gate line G, the data line D, the first power line VDD, the second power line VSS, the first signal line RD, and the second signal line Vref are parallel to the first direction Y. The gate line G and the first power line VDD are arranged on opposite sides of the first pixel unit P1 and the second pixel unit P2, respectively. Specifically, the gate line G and the first power line VDD are arranged in the second direction X on the opposite sides of the first pixel unit P1 and the second pixel unit P2. The first signal line RD is disposed on a side of the gate line G close to the first power line VDD, and the second power line VSS is disposed on a side of the first signal line RD close to the first power line VDD. The data lines D and the second signal line Vref are arranged between the first power line VDD and the second power line VSS. The first driving assembly 17, the second driving assembly 18, the first light-emitting assembly 16, and the second light-emitting component 19 are located between the first power line VDD and the second power line VSS. The sub-driving groups 171 in the first driving assembly 17 and the second driving assembly 18 are arranged in the second direction X. Each of the data lines D is disposed on a side of a corresponding one of the sub-driving groups 171 and its corresponding light-emitting device 161. With this structure, wirings, the sub-driving groups 171, and the light-emitting devices 161 will generate heat when operating. By properly distributing the wirings, the sub-driving groups 171, and the light-emitting devices 161, the wirings, the sub-driving groups 171, and the light-emitting devices 161 are evenly distributed, so that the display panel 10 can generate heat evenly to prevent abnormality of the display panel 10 caused by heat concentration, thereby improving reliability of the display panel 10.

Specifically, as shown in FIG. 6, the display panel 10 includes a plurality of first pixel units P1 and a plurality of second pixel units P2. The first pixel units P1 and the second pixel units P2 are disposed in an array. In the first direction Y, that is, in a column direction, the first pixel units P1 and the second pixel units P2 are alternately arranged. In the second direction X, that is, in a row direction, the pixel units of a 2n^{th} row are the second pixel units P2, and the pixel units of a 2n+1^{th} row are the first pixel unit P1, where n is a natural number.

Specifically, as shown in FIG. 8, the display panel 10 further includes a plurality of first switching lines S1 being parallel to the second direction X. The gate line G is contact-connected to the first transfer line S1 and is electrically connected to the control terminal of the second thin-film transistor T2 through the first switching line S1.

Specifically, as shown in FIG. 8, the display panel 10 further includes a plurality of second switching lines S2 being parallel to the second direction X. The first power line VDD is contact-connected to the second switching line S2 and is electrically connected to the input terminal of the first thin-film transistor T1 through the second switching line S2.

Specifically, as shown in FIG. 8, the display panel 10 further includes a plurality of third switching lines S3 being parallel to the second direction X. The second power line VSS is contact-connected to the third switching line S3 and is electrically connected to the second pad Pad2 through the third switching line S3.

Specifically, as shown in FIG. 8, the display panel 10 further includes a plurality of fourth switching lines S4 being parallel to the second direction X. The first signal line RD is contact-connected to the fourth switching line S4 and is electrically connected to the control terminal of the third thin-film transistor T3 through the fourth switching line S4.

Specifically, as shown in FIG. 8, the display panel 10 further includes a plurality of fifth switching lines S5 being parallel to the second direction X. The second signal line Vref is contact-connected to the fifth switching line S5 and is electrically connected to the input terminal of the third thin-film transistor T3 through the fifth switching line S5.

Specifically, in a same pixel unit (the first pixel unit P1 or the second pixel unit P2), the input terminal of the first thin-film transistor T1 of the red light-emitting device 1611, the input terminal of the first thin-film transistor T1 of the green light-emitting device 1612, and the input terminal of the first thin-film transistor T1 of the blue light-emitting device 1613 are electrically connected to different data lines D. The control terminal of the second thin-film transistor T2 of the red light-emitting device 1611, the control terminal of the second thin-film transistor T2 of the green light-emitting device 1612, and the control terminal of the second thin-film transistor T2 of the blue light-emitting device 1613 are electrically connected to a same gate line G. The control terminal of the third thin-film transistor T3 of the red light-emitting device 1611, the control terminal of the third thin-film transistor T3 of the green light-emitting device 1612, and the control terminal of the third thin-film transistor T3 of the blue light-emitting device 1613 are electrically connected to a same first signal line RD. The input terminal of the third thin-film transistor T3 of the red light-emitting device 1611, the input terminal of the third thin-film transistor T3 of the green light-emitting device 1612, and the input terminal of the third thin-film transistor T3 of the blue light-emitting device 1613 are electrically connected to a same second signal line Vref.

Specifically, the display panel 10 further includes a plurality of second pixel groups PG2 arranged in the first display area AA1. The first pixel groups PG1 and the second pixel groups PG2 are distributed in an array.

Specifically, a structure of the first pixel group PG1 is the same as that of the second pixel group PG2, that is, the second pixel group PG2 also includes the first pixel unit P1 and the second pixel unit P2. In addition, the first pixel unit P1 and the second pixel unit P2 in the second pixel group PG2 are disposed in an axisymmetric arrangement.

Specifically, a pixel pitch of the first pixel group PG1 is equal to a pixel pitch of the second pixel group PG2, so that the display panel 10 can emit light uniformly. It should be noted that the pixel pitch refers to a center-to-center distance between two adjacent pixel units.

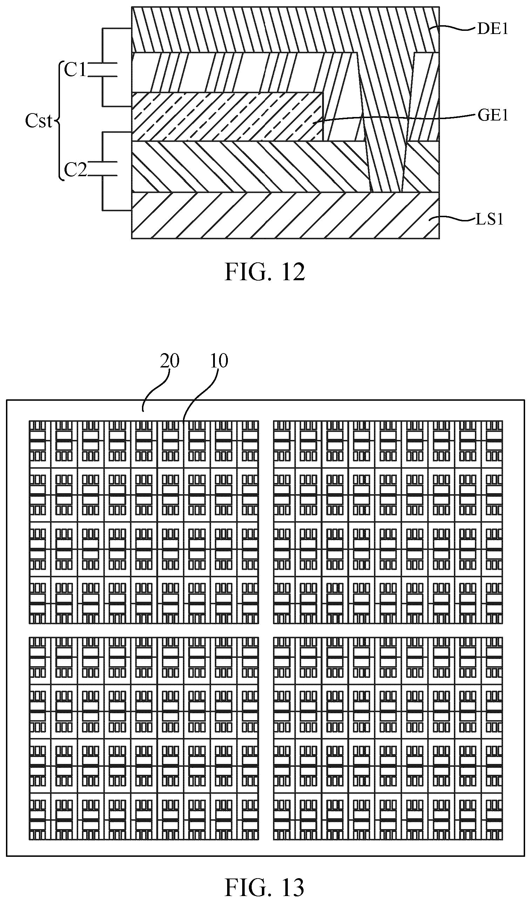

Referring to FIG. 13, an embodiment of the present application further provides a spliced display module, which includes at least two display panels 10 as described above, and the at least two display panels 10 are spliced together. The spliced display module can be a fixed terminal, such as a desktop computer, a television, a large-sized display screen, and the like. In this embodiment, the spliced display module further includes a terminal body 20. The terminal body 20 is a casing, and the display panel 10 is fixed on the terminal body 20.

An embodiment of the present application further provides a method of manufacturing a spliced display module, including:
Step B1: as shown in FIG. 6, providing at least two display panels 10, wherein each of the display panels 10 adopts the display panel 10 in the above-mentioned embodiments and includes a negative tolerance area NTA located on a side of the second display area AA2 away from the first display area AA1.
Step B2: as shown in FIG. 6, removing the negative tolerance area NTA of the display panel 10. Specifically, the negative tolerance area NTA of the display panel 10 can be removed by laser cutting and grinding, but not limited thereto.
Step B3: as shown in FIG. 13, splicing at least two of the display panels 10 together to obtain the spliced display module.

Specifically, a width of the negative tolerance area NTA is greater than or equal to 0.2 millimeters (mm), and a seam between two adjacent display panels 10 can be eliminated by cutting the negative tolerance area NTA.

Further, the width of the negative tolerance area NTA is less than or equal to 0.6 mm, which can prevent the waste of materials due to a large negative tolerance area NTA.

The above describes in detail the display panel, the splicing display module, and the method of manufacturing a splicing display module provided in the embodiments of the present application. Specific examples are used in this article to illustrate the principles and implementation of the application, and the descriptions of the above examples are only used to help understand the methods and core ideas of the application; In addition, for those skilled in the art, according to the idea of the application, there will be changes in the specific implementation and the scope of application. In summary, the content of this specification should not be construed as a limitation of the application.

## Claims

1. A display panel, comprising:
a first display area and a second display area located at a periphery of the first display area at least in a first direction; and
a plurality of first pixel groups arranged in the second display area, wherein each of the first pixel groups comprises a first driving assembly, a second driving assembly, a first light-emitting assembly, and a second light-emitting assembly, wherein the first driving assembly is electrically connected to the first light-emitting assembly, and the second driving assembly is electrically connected to the second light-emitting assembly;
wherein in the first pixel group, the first driving assembly is arranged on a side of the first light-emitting assembly in the first direction, the second driving assembly is arranged on a side of the first driving assembly away from the first light-emitting assembly in the first direction, and the second light-emitting assembly is arranged on a side of the second driving assembly away from the first driving assembly in the first direction.

2. The display panel of claim 1, wherein in the first pixel group, the first driving assembly and the second driving assembly are arranged in an axisymmetric arrangement, and the first driving assembly and the second driving assembly have a same structure.

3. The display panel of claim 1, further comprising a plurality of second pixel groups disposed in the first display area, and the first pixel groups and the second pixel groups are distributed in an array.

4. The display panel of claim 3, wherein the first pixel group and the second pixel group have a same structure.

5. The display panel of claim 3, wherein a pixel pitch of the first pixel group is equal to a pixel pitch of the second pixel group.

6. The display panel of claim 1, wherein the first driving assembly comprises at least a first thin-film transistor, the first light-emitting assembly comprises at least a light-emitting device, and the first thin-film transistor is electrically connected to a corresponding one of the light-emitting devices.

7. The display panel of claim 6, further comprising a plurality of gate lines, a plurality of data lines, a plurality of first power lines, and a plurality of second power lines;
wherein the first driving assembly further comprises at least a second thin-film transistor having a control terminal electrically connected to a corresponding one of the gate lines, an input terminal of the second thin-film transistor is electrically connected to a corresponding one of the data lines, an output terminal of the second thin-film transistor is electrically connected to a control terminal of the first thin-film transistor, and an input terminal of the first thin-film transistor is electrically connected to a corresponding one of the first power lines; and
wherein the light-emitting device comprises a first pin and a second pin, an output terminal of the first thin-film transistor is electrically connected to the first pin of the light-emitting device, and the second pin of the light-emitting device is electrically connected to a corresponding one of the second power lines.

8. The display panel of claim 7, wherein the first driving assembly further comprises at least a storage capacitor, and the output terminal of the second thin-film transistor is connected to the output terminal of the first thin-film transistor through the storage capacitor.

9. The display panel of claim 6, wherein the display panel further comprises a first signal line and a second signal line;
wherein the first driving assembly further comprises at least a third thin-film transistor having a control terminal electrically connected to the first signal line, an input terminal of the third thin-film transistor is electrically connected to the second signal line, and an output terminal of the third thin-film transistor is electrically connected to the output terminal of the first thin-film transistor.

10. A spliced display module, comprising at least two display panels spliced together, wherein the display panels each adopt the display panel of claim 1.

11. The spliced display module of claim 10, wherein in the first pixel group, the first driving assembly and the second driving assembly are arranged in an axisymmetric arrangement, and the first driving assembly and the second driving assembly have a same structure.

12. The spliced display module of claim 10, wherein the display panel further comprises a plurality of second pixel groups disposed in the first display area, and the first pixel groups and the second pixel groups are distributed in an array.

13. The spliced display module of claim 12, wherein the first pixel group and the second pixel group have a same structure.

14. The spliced display module of claim 12, wherein a pixel pitch of the first pixel group is equal to a pixel pitch of the second pixel group.

15. The spliced display module of claim 10, wherein the first driving assembly comprises at least a first thin-film transistor, the first light-emitting assembly comprises at least a light-emitting device, and the first thin-film transistor is electrically connected to a corresponding one of the light-emitting devices.

16. The spliced display module of claim 15, wherein the display panel further comprises a plurality of gate lines, a plurality of data lines, a plurality of first power lines, and a plurality of second power lines;
wherein the first driving assembly further comprises at least a second thin-film transistor having a control terminal electrically connected to a corresponding one of the gate lines, an input terminal of the second thin-film transistor is electrically connected to a corresponding one of the data lines, an output terminal of the second thin-film transistor is electrically connected to a control terminal of the first thin-film transistor, and an input terminal of the first thin-film transistor is electrically connected to a corresponding one of the first power lines; and
wherein the light-emitting device comprises a first pin and a second pin, an output terminal of the first thin-film transistor is electrically connected to the first pin of the light-emitting device, and the second pin of the light-emitting device is electrically connected to a corresponding one of the second power lines.

17. The spliced display module of claim 16, wherein the first driving assembly further comprises at least a storage capacitor, and the output terminal of the second thin-film transistor is connected to the output terminal of the first thin-film transistor through the storage capacitor.

18. The spliced display module of claim 15, wherein the display panel further comprises a first signal line and a second signal line;
wherein the first driving assembly further includes at least a third thin-film transistor having a control terminal electrically connected to the first signal line, an input terminal of the third thin-film transistor is electrically connected to the second signal line, and an output terminal of the third thin-film transistor is electrically connected to the output terminal of the first thin-film transistor.

19. A method of manufacturing a spliced display module, the method comprising:
Step B1: providing at least two display panels, wherein each of the display panels comprises a first display area, a second display area, and a negative tolerance area, a plurality of first pixel groups arranged in the second display area, wherein the second display area is located at a periphery of the first display area at least in a first direction, and the negative tolerance area is located on a side of the second display area away from the first display area, wherein a plurality first pixel groups are arranged in the second display area, each of the first pixel groups comprises a first driving assembly, a second driving assembly, a first light-emitting assembly, and a second light-emitting assembly, wherein the first driving assembly is electrically connected to the first light-emitting assembly, and the second driving assembly is electrically connected to the second light-emitting assembly, wherein in the first pixel group, the first driving assembly is arranged on a side of the first light-emitting assembly in the first direction, the second driving assembly is arranged on a side of the first driving assembly away from the first light-emitting assembly in the first direction, and the second light-emitting assembly is arranged on a side of the second driving assembly away from the first driving assembly in the first direction;
Step B2: removing the negative tolerance area of the display panel; and
Step B3: splicing the at least two display panels together to obtain the spliced display module.

20. The method of manufacturing the spliced display module of claim 19, wherein in Step B1, a width of the negative tolerance area is greater than or equal to 0.2 millimeters (mm), and the width of the negative tolerance area is less than or equal to 0.6 mm.
